# EUROPEAN PATENT APPLICATION

(11) **EP 4 852 318 A1**
(43) Date of publication of application: **09.12.2026**
(21) Application number: 25180690.7
(22) Date of filing: 04.06.2025
(51) Int. Cl.: H03F 3/70

(54) **CHARGE AMPLIFIER, CHARGE DISCRIMINATOR AND RECEIVER CIRCUIT FOR A SPREAD SPECTRUM MODULATION SIGNAL**

(71) Applicant: EM Microelectronic-Marin SA, 2074 Marin-Epagnier (CH)
(72) Inventor: NERAD, Jiri, 15800 Praha (CZ)
(74) Representative: ICB SA

(57) **Abstract**

In one aspect the present invention concerns a periodically switchable charge amplifier circuit (12) for amplifying an analog input signal (VRX), the switchable charge amplifier circuit (12) comprising:
- a status capacitor (CST),
- a track switch (TRACK_P) and at least a first reset switch (CLEAR_P) alternately switchable by a master clock signal (VSW), and
- an amplifier (OA) parallel to the status capacitor (CST),
- wherein the status capacitor (CST) is chargeable by closing the track switch (TRACK_P) and wherein the status capacitor (CST) is dischargeable by closing the at least first reset switch (CLEAR_P).

## Description

### Field of the invention

The present invention relates to the field of charge amplifier circuits, charge discriminator circuits and to the field of receiver circuits, specifically to spread spectrum receivers with high suppression of low-frequency interference, specifically for position indicators and respective systems.

### Background

Position detection devices are nowadays widely implemented for the communication between a tablet or computer and a suitable active stylus or electronic pen. Here, an electrostatic communication system is required using a waveform for a direct sequence spread spectrum modulation. It is generally required to transmit and to receive a predefined set of square wave signal patterns to conduct a position measurement of the stylus or electronic pen with respect to a display of the tablet or computer.

One example of an analog circuit designed and configured for stylus applications is known from US 2018/0095495 A1. There, a passive high-pass stage is not only used to suppress interference but also to perform the key task, namely the edge detection of the waveform signal pattern. Digital signals from an edge detector are then used for full reconstruction of a useful input signal waveform. Finally, a correlator or matched filter is used to calculate a correlation factor between the reconstructed input signal and a predefined reference signal. Most prior art systems typically require an analog high-pass filter in order to suppress the low-frequency interference.

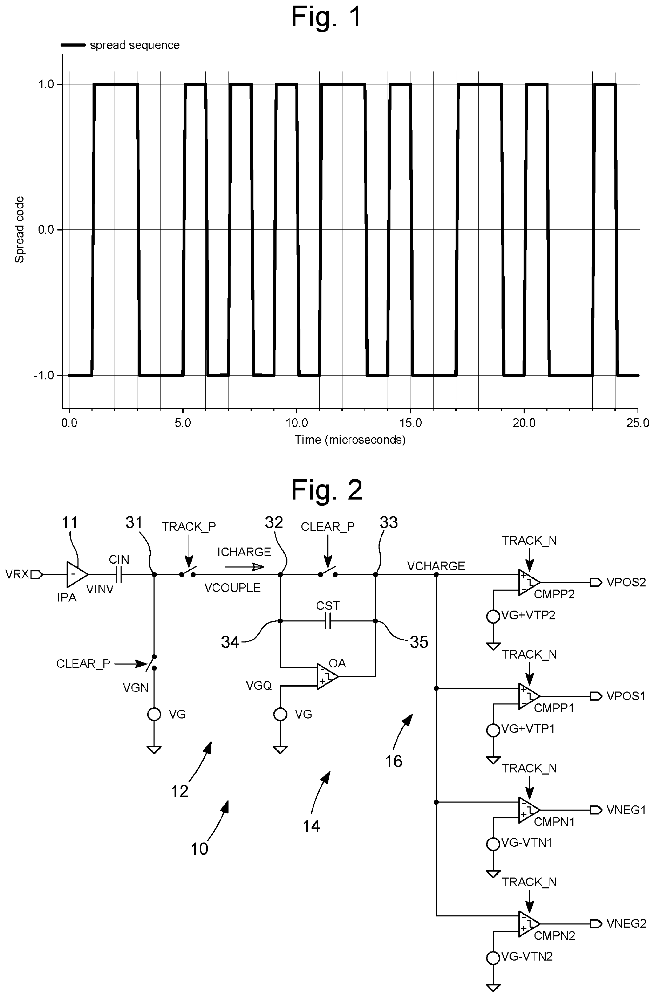

Generally, electrostatic communication systems using the baseband form of direct sequence spread spectrum modulation are designed to transmit and receive a predefined set of square wave signal patterns such as the one illustrated in Figure 1. It is important to note that such a signal can be considered digital as it can only have a discrete set of values that can only change at discrete moments of time. Each signal pattern is designed to have the auto-correlation with a dominant peak and minimum cross-correlation with all other patterns of a set. The reception of such a signal stream is based on the detection of any of the predefined patterns in the full received signal that comprises the transmitted useful signal, random noise and deterministic interference. Here, the detection is based on calculating a cross-correlation factor between the received signal and one or more expected patterns of the predefined set. The block to calculate said cross-correlation factor is typically referred to as "correlator" or "matched filter".

With generally known architectures the first step is performing the analog to digital conversion to obtain a sampled and quantized data stream representing the input analog signal. Next, the digital data stream can be used to calculate the correlation factor. This architecture requires a relatively high sampling rate as well as a relatively high bit resolution in both the analog digital converter and the digital correlator, preventing a low power implementation.

A simpler architecture, taking advantage of specific properties of the spread spectrum signal uses the fact that, contrast to the low frequency interference, the spread spectrum signal includes sharp edges that carry the critical timing information. The detection process begins with extracting the edge timing that may be represented as two single bit digital signals, where a pulse in the first digital signal indicates a rising edge in the analog signal at the receiver input and a pulse in the second digital signal indicates a falling edge in the analog signal at the receiver input. Next, the edge timing information, in the form of two digital signals or otherwise, is used to reconstruct the original useful signal which is typically a single bit digital signal. Finally, the reconstructed signal is used to calculate the correlation factor. Here, the useful signal is represented by one or two digital signals with single bit resolution.

However, all prior art systems require an analog high pass filter in order to suppress the low frequency interference. At the same time, the low power implementation of front amplifier stages brings inherent limitation of the maximum frequency that the system can process. Therefore, the useful signal band can become quite narrow as it spans from the cutoff frequency of the high pass filter to the cutoff frequency of the front amplifier stages where the former is limited by the interference and the latter is limited by the available power. Besides, for such combination it is not possible to find a method to optimize the full system performance as there are no direct relations between the interference bandwidth, the resulting system power dissipation and the signal detection performance. Consequently, all prior art systems can only be optimized experimentally, leading to sub optimum designs.

It is therefore desirable to provide an improved discrimination between the useful signal edges and the transient signal slope due to low frequency interference, which offers a performance that is superior to prior art solutions, which does not require an analog high pass filter to suppress the interference signal, which brings a direct and straightforward relation between the time window of the discriminator on one hand and the bandwidth and hence the power of the front amplifiers on the other hand and to thereby optimize the entire system design.

### Summary of the invention

The above-mentioned drawbacks and shortcomings will be effectively solved by a periodically switchable charge amplifier circuit, by a charge discriminator circuit and by a receiver circuit as defined by the features of the independent claims. Further embodiments and examples of the invention are subject matter of respective dependent claims.

In one aspect the present invention and hence the present disclosure relates to a periodically switchable charge amplifier circuit for amplifying an analog input signal. The switchable charge amplifier circuit comprises a status capacitor, a track switch and at least a first reset switch, which are alternately switchable by a clock signal or by various clock signals, e.g. derived from a master clock signal. The periodically switchable charge amplifier circuit further comprises an amplifier, which is parallel to the status capacitor. In operation the status capacitor is chargeable by closing the track switch and the status capacitor is dischargeable by closing the at least first reset switch. Insofar, the periodically switchable charge amplifier circuit can be operated in at least two different operation modes, which are defined by closing the track switch while keeping the reset switch open, and by closing the reset switch while keeping the track switch open.

Accordingly, and in the reset mode, the reset switch is closed while the track switch is open. Conversely, in the track mode, the track switch is closed while the reset switch is open.

According to some examples, the track switch and the at least first reset switch are switchable in a non-overlap way. Hence, the track switch is transferable from an Off state into an On state only after the at least first reset switch has been transferred from an On state into an Off state. Vice versa, switching of the at least first reset switch from the Off state into the On state is only possible or allowed after the track switch has been transferred from the On state into the Off state. In this way it can be guaranteed, that only one of the track switch and the at least first reset switch is active at a time.

By alternately switching the track switch and the at least first reset switch the status capacitor can be selectively connected to the analog input signal, typically when closing the track switch. In the respective track mode, the status capacitor can be charged by the input current, which is caused or induced by the analog input signal. Moreover, by way of the high-gain amplifier parallel to the status capacitor in combination with the method of scaling the size of the status capacitor, the respective amount of voltage present across the status capacitor due to the process of charging the status capacitor during the track mode can be even scaled, and consequently, the signal gain of the input cascade adjusted.

After completion of a phase during the track mode, the charge amplifier circuit is switched into the reset mode and the status capacitor is discharged again. In this way, the status capacitor can be periodically charged and discharged in accordance with a sequence as defined by the master clock signal.

By repeatedly charging the status capacitor the periodically switchable charge amplifier transforms or integrates its instantaneous input current into an instantaneous output voltage, wherein the input current flows into the status capacitor and the output voltage represents the charge as accumulated in the status capacitor.

According to some examples the amplifier has a comparatively large gain and is connected or coupled to the status capacitor in a negative feedback configuration. In this way, there can be ensured a virtually zero voltage difference between an analog signal ground on one hand and an input node of the amplifier and/or of the track switch on the other.

Accordingly, a difference between an output voltage at an output node of the periodically switchable charge amplifier circuit and a voltage at an analog signal ground may be equal to the voltage across the status capacitor, which is proportional to the charge accumulated in the status capacitor.

When switched into the reset mode, e.g., by activating the at least first reset switch, the status capacitor can be discharged, resulting in a zero charge and a zero voltage difference between the voltage at the analog signal ground and the output voltage of the periodically switchable charge amplifier circuit.

According to a further example the at least first reset switch is arranged in parallel to the status capacitor. In this way and by closing the at least first reset switch the status capacitor can be discharged. By opening the reset switch, the status capacitor can be charged by an input current derivable from or induced by the analog input signal.

According to a further example the charge amplifier circuit comprises an input node, which is selectively connectable to the arrangement of the status capacitor, the amplifier and the at least first reset switch via the track switch.

According to some examples, the first reset switch is arranged in parallel to the status capacitor. Moreover, the amplifier, which may be in a negative feedback configuration may be arranged parallel to the status capacitor. Hence, an inverting input of the amplifier, which may be implemented as an operational amplifier, may be connected to a first node of the status capacitor. The output of the amplifier may be connected to a second node of the status capacitor.

Moreover, and according to another example the input node is capacitively coupled to the analog input signal via an input capacitor. By way of a capacitive coupling between the input node of the periodically switchable charge amplifier circuit and the analog input signal there can be provided an effective capacitive coupling between the analog input signal and the periodically switchable charge amplifier circuit.

According to a further example the input node is connectable to a signal ground via a second reset switch, which is concurrently switchable with the at least first reset switch.

According to further examples, the track switch may be arranged between the input node and the first reset switch. It may be located between the input node and an intermediate node, through which the status capacitor, the first reset switch and the amplifier are connectable to the track switch and further to the input node.

Accordingly, the analog input signal can be coupled to the input node of the periodically switchable charge amplifier circuit through a capacitive coupling network comprising the input capacitor and at least two switches, namely the track switch and the second reset switch, which are controllable by alternating switching or clock signals derivable from the clock generator.

When the track switch is active, the input capacitor is connected to the input node of the periodically switchable charge amplifier circuit and an entire cascade of the analog input, the coupling network and the charge amplifier act as a noninverting voltage amplifier that copies and amplifies any voltage change at the input to the charge amplifier output.

When the first and second reset switches are active, the input capacitor is connected to a noisy signal ground, passing no signal to any of the following stages. Moreover, when the first and second reset switches are active, the periodic charge amplifier is initialized by discharging the status capacitor.

In this way, the periodically switchable charge amplifier circuit provides an amplification of an analog input signal, wherein its amplification is periodically interrupted by a reset signal that causes the output level of the periodically switchable charge amplifier to be set to a predefined reference output level.

Also, this way of switched capacitive coupling allows to reduce or prevent any significant kickback into or towards the analog input signal that would be due to the periodic operation of the periodically switchable charge amplifier circuit.

According to a further aspect the present invention and disclosure also relates to a charge discriminator circuit to generate digital output signals on the basis of an analog input signal. The charge discriminator circuit comprises a charge amplifier circuit as described above, i.e., a periodically switchable charge amplifier circuit as described above. The charge discriminator circuit further comprises at least a first latched comparator and a second latched comparator connected to an output node of the charge amplifier circuit.

The first latched comparator is configured to generate a first digital output signal in response to detecting a signal at the output node of the charge amplifier comprising voltage value above a first predefined threshold signal. The second latched comparator is configured to generate a second digital output signal in response to detecting a signal at the output node of the charge amplifier comprising a voltage value below a second predefined threshold signal.

In this way and by way of a combination of the periodically switchable charge amplifier with the first and second latched comparators the output voltage of the charge amplifier can be duly compared with a set of predefined reference voltages, which may be centred around an analog signal ground voltage.

Here, the latched comparators may be also clocked with a latch signal in such a way that the comparison decision is made on a rising age of a respective latch signal, which may be generated simultaneously to the falling edge of the track switch signal, which induces or controls the activity of the track switch. Accordingly, the comparison decision can be made at the end of a time window, where the charge amplifier is in a track mode and wherein the cascade of the analog input, the coupling network and the periodically switchable charge amplifier may be thus operable to transfer the analog input signal changes since last reset.

Moreover, the digital output signals of the first or second latched comparators may be updated when a comparison decision is made at the time of a rising edge of a respective latch signal which may be done concurrently with a falling edge of the track signal by way of which the track switch is operated.

The digital output signals of the latched comparators may remain constant until the next falling edge of the latch signal. Furthermore, an additional digital latch stage may be used to process the output signal of each comparator, wherein the additional digital latch is controlled by a complementary control signal obtained by inverting the polarity of the latch control signal of the respective latched comparator. In this way, the duration of the resulting digital signal may be extended in such a way that it remains constant for one full clock period, that is, until the next rising edge of the latch control signal which is simultaneous to the next falling edge of the track switch signal.

The charge discriminator circuit is generally operable with a first and with a second latched comparator providing a first and a second digital output signal, respectively. Here, comparison thresholds for the first and second comparators may be symmetrically centred around an analog signal ground voltage.

Then the first digital output signal of the first latched comparator may be then indicative that the voltage as obtained at the output node of the periodically switchable charge amplifier has been subject to a fast rising transition induced by a fast rising transition of the system input voltage. Here and for the purpose of a subsequent calculation of a correlation factor, this may correspond to a signal value of +1.

Conversely, the second digital output signal of the second latched comparator may flag the presence of a fast falling transition of the system input voltage and hence of the output voltage obtainable at the output node of the periodically switchable charge amplifier. Here and for the purpose of a subsequent calculation of a correlation factor, this may correspond to a signal value of -1.

Moreover, and according to another example the first latched comparator and the second latched comparator are arranged in parallel. They may be both connected with an input to the output node of the periodically switchable charge amplifier.

According to a further example the charge discriminator circuit further comprises a third latched comparator and a fourth latched comparator, which are likewise connected to the output node of the charge amplifier circuit. The third latched comparator is configured to generate a third digital output signal in response to detecting the signal at the output node of the charge amplifier comprising a voltage value above a third predefined threshold signal. The fourth latched comparator is configured to generate a fourth digital output signal in response to detecting the signal at the output node of the charge amplifier comprising a voltage value below a fourth predefined threshold signal.

Accordingly, and since the charge amplifier is periodically initialized, the respective digital signals are obtainable at an output of one of the first, the second, the third and the fourth latched comparators, and especially, when the analog input signal has been subject to a significant rising or falling transition, which rising or falling transition may lead to the generation of at least one of the first and the third digital output signal indicating a rising transition above the first or the second predefined threshold signal or to the generation of at least one of the second and the fourth digital output signal indicating a falling transition below the second or the fourth predefined threshold signal.

In this way, the digital output of the charge discriminator circuit is configured to provide and/or to indicate a magnitude of a rising and/or of a falling transition of the analog input signal. Here and for the purpose of a subsequent calculation of the correlation factor, the first or third digital output signals of the respective first or third latched comparators may correspond to signal values of +1 or +2, respectively. Conversely, the respective second and fourth digital output signal obtainable at the output of the respective second and fourth latched comparator may provide signal values of -1 or -2, respectively.

According to another aspect the present disclosure or invention further relates to a receiver circuit. The receiver circuit comprises at least one of a charge amplifier circuit as described above and a first charge discriminator circuit as described above. In addition, the receiver circuit further comprises a clock generator coupled to at least one of the charge amplifier circuit and at least one of the first and the second latched comparators of the first charge discriminator circuit.

According to some examples the receiver circuit comprises a charge discriminator circuit as described above, which includes a charge amplifier circuit as described above as well as the first and second latched comparators as described above. According to some examples, the receiver circuit comprises a charge amplifier circuit as described above and a first charge discriminator circuit, which comprises a first latched comparator, a second latched comparator, a third latched comparator and a fourth latched comparator. Generally, the number of latched comparators can be arranged or connected in parallel. Each comparator may be connected or coupled to an output node of the charge amplifier circuit.

An output signal as provided by the charge amplifier circuit may be present to the input of each and any of the first, second, third and fourth latched comparators. According to some examples, the numerous latched comparators may form or constitute a bank of latched comparators.

The clock generator may be configured to provide switching signals for the track switch and for the at least first reset switch. The clock generator may be further configured to provide or to generate a track switch signal and a reset switch signal, wherein the present switch signal is configured to operate or to switch the at least the first reset switch and/or the second reset switch of the periodically switchable charge amplifier circuit.

According to some examples the clock generator may be also coupled or connected to at least some or to any of the latched comparators of the charge discriminator circuit. In this way, the clock generator may be operable to latch the respective latched comparator on the basis of the master clock signal or latch signal.

According to a further example the clock generator is configured to derive or to provide a track switch signal and a reset switch signal on the basis of the master clock signal. The track switch signal and the reset switch signal are active alternately and in a non-overlapping way. In other words and as mentioned before, only one of the track switch signal and the reset switch signal is active at a time. Before one of the track switch signal and the reset switch signal is switched from an inactive state into an active state, e.g., before at least one of the track switch signal and the reset switch signal is switched from a logical zero to a logical one the other one of the track switch signal and the reset switch signal will be deactivated and hence transferred from an active state into an inactive state beforehand, e.g., by switching from a logical one to a logical zero. In this way it can be avoided, that both of the track switch signal and the reset switch signal are active or at a logical one at a time.

According to a further example the clock generator is coupled to the first and to the second latched comparators and is further configured to generate a latch signal on the basis of the master clock signal to periodically switch at least one of the first and the second latched comparators into a latched state.

According to some examples, the clock generator is configured to provide all of the available latched comparators of the charge discriminator circuit with a respective latch signal. Here, all comparators of the charge discriminator circuit may be clocked with the latch signal in such a way that the comparison decision of the respective latched comparators is made on a rising edge of the latch signal, which may be simultaneous to the falling edge of the track switch signal. Here and according to some examples, the latch signal may be obtained or may be generated by inverting the track switch signal.

Accordingly, a comparison decision provided by the bank of latched comparators can be made at the end of a time window, where a charge amplifier is in the track mode and wherein the cascade of the analog input signal, the coupling network, the periodically switchable charge amplifier copies or transfers the system input signal changes without inversion to the output node of the periodically switchable charge amplifier circuit.

Here, the digital output signals of all comparators can be updated when the comparison decisions are made at the time of a rising edge of the latch signal and at the time of a falling edge of the track switch signal.

Moreover, the digital output signals obtainable at the respective comparators remains constant until the next falling edge of the latch signal. Moreover, an additional digital latch stage may be added at the output of each comparator to extend the duration and keep the resulting digital signal constant for one full clock period, that is, until the next rising edge of the latch signal and/or until the next falling edge of the track switch signal.

According to a further example the receiver circuit further comprises a second charge discriminator circuit as described above. The first charge discriminator circuit is coupled to a first clock signal output of the clock generator and the second charge discriminator circuit is coupled to a second clock signal output of the clock generator. The second clock signal output is phase shifted to the first clock signal output of the clock generator.

Alternatively, the first and second charge discriminator circuit may be driven or operated by separate clock generators, which may be synchronized or mutually coupled to provide the respective master clock signals or the respective track switch signals, reset switch signals or latch signals that are phase shifted. By making use of a first and a second charge discriminator circuit, which are each connected or coupled to one and the same input signal, a potential risk of a failed detection can be effectively avoided. Otherwise, and with only one charge discriminator circuit there might remain a potential risk of a failed detection when a useful edge on the analog input signal does not occur within the time window of the charge discriminator circuit, that is, the timeslot when the master clock signal is high and the charge amplifier is in the track mode. Such a risk might be significant because the input signal might be completely asynchronous to the receiver clock but the clock frequencies in both the transmit and the receive side are precisely matched during manufacture to comply with a communication standard.

Here, and by way of implementing a first charge discriminator circuit and a second charge discriminator circuit, e.g., switched or connected in parallel, there can be provided a time window interleaving and hence a rather stable and robust setup of a respective receiver circuit.

Here, the parallel combination of a first charge discriminator circuit and a second charge discriminator circuit may be connected to one and the same input signal, e.g., to one and the same inverting preamplifier through which the input signal may be provided to the coupling network. Such a configuration is particularly possible because the coupling stage of the periodically switchable charge amplifier of the charge discriminators only causes a negligible kick back into the optional preamplifier stage at the analog signal input.

According to a further example, the overlap times during which the first and the second clock signal outputs have the same signal level are substantially equal. In this way there can be provided a rather precise time window interleaving. The first and the second master clock signals may be shifted copies of the same pattern and may be timed in such a way that the periods of a high-level, where the related periodic charge amplifiers are in track mode, overlap by first and second time intervals or time spaces.

Therefore, and at any given point of time it may be guaranteed that at least one periodic charge amplifier is in the track mode and will stay in this mode for a at least such an amount of time that is the smaller of the two overlap times.

In effect and with the arrival of an input signal being completely asynchronous with respect to the internal master clock signals, the timing waveforms need to be generated in such a way that the overlap times are substantiality equal or identical.

Furthermore and according to another example the receiver circuit also comprises a digital implementation of a differential correlator or matched filter connected to an output of at least one OR gate, which is connected to an output of the first charge discriminator circuit and to an output of the second charge discriminator circuit, respectively. Mutually corresponding outputs of the first and the second charge discriminator circuits, such as the first, second, third or fourth digital output of the respective first, second, third or fourth latched comparators of the first charge discriminator circuit may be pairwise coupled to the respective first, second, third or fourth digital outputs of latched comparators of the second charge discriminator circuit by a respective OR gate. An output of the bank of OR gates may be then used as an input to the differential matched filter.

Accordingly, a first signal output of the first latched comparator of the first charge discriminator circuit may be used as a first input of a first OR gate. The second input of the first OR gate may be connected to the first digital output of the first latched comparator of the second charge discriminator circuit. Due to the phase shifted operation of the first and second charge discriminator circuits, there will be always one of the respective periodically switchable charge amplifiers that is in the track mode even for any arbitrary or completely asynchronous arrival of a rising or falling transition of the input signal.

According to a further example the receiver circuit further comprises an inverting preamplifier, which is coupled to the at least one periodically switchable charge amplifier circuit. In some examples, wherein the receiver circuit comprises a first and the second charge discriminator circuit, each of which comprises the respective first and second charge amplifier circuit, the inverting preamplifier and specifically a signal output of the inverting preamplifier can be connected to a respective input node or input nodes of both the first charge amplifier circuit of the first charge discriminator circuit and the second charge amplifier circuit of the second charge discriminator circuit.

In this way, and when implementing the first and second charge discriminator circuit, a common inverting preamplifier may be shared with the charge discriminator circuits. Such a paired or combined coupling to the output of the inverting preamplifier is possible since the coupling stage in the periodically switchable charge discriminator circuits only presents a negligible kick back into the preceding preamplifier stage.

In effect, a combination of two periodically switchable charge amplifiers and hence of the respective periodically switchable charge discriminators with a time interleaving can be used to ensure that an asynchronous edge of an input signal can be properly detected even when the frequency of the master clock signal is high, meaning a short timeslot for the track mode of each periodic charge amplifier that determines the discrimination time window. This brings the advantage of superior discrimination performance as the short time window minimizes the amplitude of a saw-type waveform at the output of each periodic charge amplifier or periodic charge discriminator originating from the slower edges or ramps related to low frequency interference. In this way, there can be provided an effective suppression of a disturbing signal.

At the same time, the discrimination time window can be designed to match the rise and fall times of the front stage preamplifier, e.g., the inverting preamplifier, which are in direct relation to its bandwidth, and in turn, power consumption. Hence, there exists a direct design path from the system requirements on the interference suppression via the discrimination time window and on the power consumption of the front stage, meaning a power efficient design with superior detection performance.

Accordingly and to summarize, the periodically switchable charge amplifier and the charge discriminator circuit provides a rather effective and useful detection of edges in an input signal of square wave type in the presence of a strong low frequency interference. The present system can be implemented by using a conventional or differential correlator or matched filter to detect the presence of a predefined pattern in a received analog input signal. Moreover, the system as described herein, i.e., the periodically switchable charge amplifier, the charge discriminator and/or the respective receiver circuit and any of its components may be configured to use a baseband form of a direct sequence spread spectrum modulation. The presently described system further provides and supports a signal transmission and reception over an electrostatic communication channel and is of particular use for implementation in a pointing or drawing device, such as a stylus or an electronic pen, e.g., in communication with a tablet computer or mobile phone.

### Brief description of the drawings

In the following, numerous examples of the details, effects and benefits of a periodically switching charge amplifier, of a charge discriminator circuit and of a receiver circuit as described above become apparent by the following description of numerous examples by making reference to the drawings, in which:
- Fig. 1 illustrates an analog input signal comprising a spread sequence,
- Fig. 2 is a schematic circuit diagram of a charge discriminator circuit comprising a periodically switchable charge amplifier,
- Fig. 3 schematically illustrates one example of a clock generator,
- Fig. 4 shows waveforms of various clock signals derivable by the clock generator,
- Fig. 5 shows some selected signals during operation of a single instance of the periodic charge discriminator,
- Fig. 6 is an example of a combination of a first and a second periodic charge discriminator,
- Fig. 7 shows a time window interleaving of first and second master clock signals for operating the first and second periodic charge discriminators according to Fig. 6,
- Fig. 8 shows some selected signals during an example operation of a combination of a first and second charge discriminator circuit with time window interleaving and
- Fig. 9 illustrates various numeric output signals generated by the parallel combination and interleaving of the first and second charge discriminator circuits with time window interleaving as described herein.

### Detailed description of the invention

Fig. 1 schematically illustrates a spread spectrum modulated signal, which may form or constitute an input signal VRX for a receiver circuit 10 as illustrated in Fig. 2. In the illustrated example the receiver circuit 10 comprises an inverting preamplifier 11 IPA by way of which the analog input signal can be provided to an input node 31 of a periodically switchable charge amplifier circuit 12.

The periodically switchable charge amplifier circuit 12 belongs to the receiver circuit 10. In addition, the receiver circuit 10 comprises a latched comparator bank 16, which is connected or coupled to an output node 33 of the periodically switchable charge amplifier circuit 12, together forming a charge discriminator circuit 14.

The periodically switchable charge amplifier 12 comprises a status capacitor CST, an amplifier OA parallel to the status capacitor CST, a track switch TRACK_P and at least a first reset switch CLEAR_P, which is also arranged in parallel to the status capacitor CST. The first reset switch CLEAR_P is located between an intermediate node 32 and the output node 33. A first node 34 of the status capacitor CST is connected to the intermediate node 32. A second node 35 of the status capacitor CST is connected to the output node 33 of the periodically switchable charge amplifier circuit 12.

Between the input node 31 and the intermediate note 32 there is provided a track switch TRACK_P, which is selectively and alternately switchable with respect to the switching of the at least first reset switch CLEAR_P.

The input node 31 is connectable to a noisy signal ground VGN via another, hence a second reset switch CLEAR_P. The input node 31 is further connected to the output of the inverting preamplifier IPA via an input capacitor CIN.

The inverting preamplifier IPA is a voltage mode amplifier with negative gain that converts the system input voltage VRX into its inverted and amplified copy VINV. This stage may also serve as a buffer stage, providing a high impedance at its input and a low impedance at its output. The periodic charge amplifier 12 transforms or integrates its instantaneous input current ICHARGE into its instantaneous output voltage VCHARGE, wherein the input current flows into the status capacitor CST and the output voltage VCHARGE represents the charge accumulated in the status capacitor CST.

The operational amplifier OA has a large gain and is connected in a negative feedback configuration, ensuring a virtually zero voltage difference between the quiet analog signal ground VGQ and the input coupling net VCOUPLE.

Hence the difference between the output voltage VCHARGE and the quiet analog signal ground VGQ is equal to the voltage across the status capacitor CST that is proportional to its charge. The periodic charge amplifier also comprises a digital control signal CLEAR_P that activates the reset switch across the status capacitor CST which in turn discharges said capacitor, resulting in zero charge and zero voltage difference between the quiet analog signal ground VGQ and the output voltage VCHARGE.

The output net of the inverting preamplifier VIN is coupled to the input net 31 of the periodic charge amplifier VCOUPLE by means of a capacitive coupling network comprising a capacitor CIN and two switches controlled by signals TRACK_P and CLEAR_P.

When the signal TRACK_P is active, the capacitor CIN is connected to the input net of the periodic charge amplifier and the entire cascade of the inverting preamplifier, coupling network and charge amplifier acts as a noninverting voltage amplifier that copies and amplifies any voltage change at the system input VRX to the charge amplifier output VCHARGE.

When the signal CLEAR_P is active, the input capacitor is connected to the noisy signal ground VGN, passing no signal to following stages. When the signal CLEAR_P is active, the periodic charge amplifier is initialized by discharging the status capacitor CST.

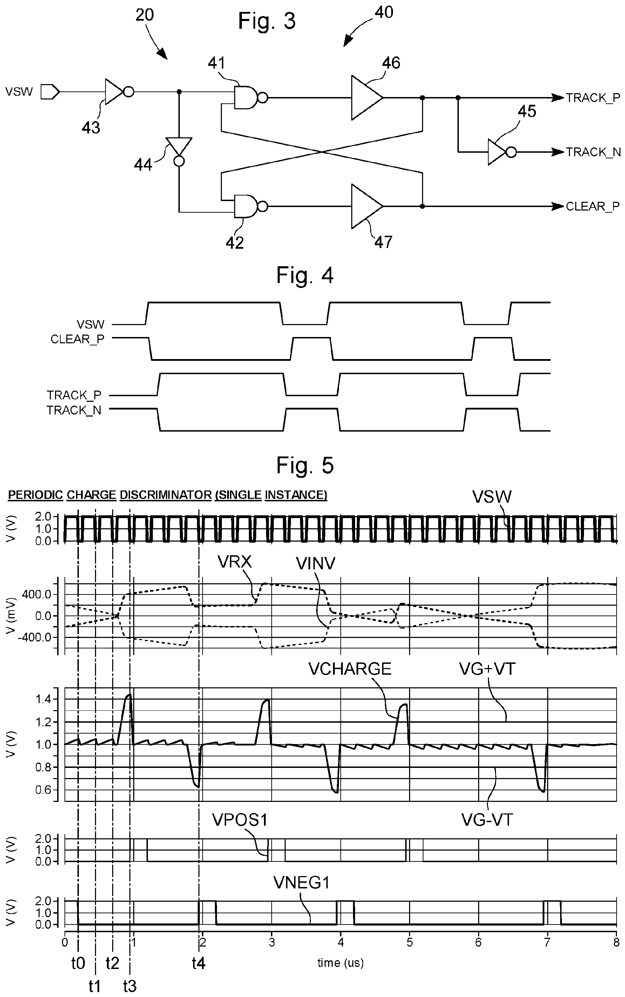

The receiver circuit 10 further comprises a clock generator 20, an example of which is illustrated in Fig. 3. The clock generator 20 comprises a kind of a RS type flip flop topology. Hence, the clock generator 20 comprises a flip-flop 40 including a first NAND gate 41, a second NAND gate 42, inverters 43, 44, 45 and delay elements 46, 47. The delay element 46 is in cascade with the first NAND gate 41. The delay element 47 is in cascade with the second NAND gate 42. One input of the NAND gate 41, 42 is connected to an inverted and a direct copy of the master clock signal, respectively, as provided by the input inverters 43, 44. The further input of the first and second NAND gate, 41, 42 is controlled by the output of the respective other NAND gate 42, 41. The respective input is particularly connected to an output of the delay element 46, 47 in cascade with the output of the respective NAND gate 41, 42.

Accordingly, a track switch signal TRACK_P is provided at the output of the first delay element 46 in series with the first NAND gate 41. A reset switch signal CLEAR_P is provided at the output of the second delay element 47 in series with the second NAND gate 42. And finally, the complementary or inverted track signal TRACK_N that forms or constitutes a latch signal is derived from the output of the first delay element 46 via the inverter 45.

Accordingly and as illustrated in Fig. 4, based on the master clock signal VSW there can be derived and provided numerous waveforms of a track switch signal TRACK_P, a reset switch signal CLEAR_P and a latch signal TRACK_N as illustrated in Fig. 4.

Fig. 5 shows example waveforms. Generally, a high level on the master clock signal VSW brings the circuit to the track mode where the input waveform is processed, whereas a low level on the master clock signal VSW brings the circuit in the reset or clear mode or into an initialization, where no signal is transferred and the status capacitor CST is discharged.

At the same time, the clock generator guarantees that the activity on the signals TRACK_P and CLEAR_P never overlaps, leaving a defined time space where none of these signals is active. Also, these clock signals in combination with the switches at the coupling capacitor CIN ensure that this circuit never presents a significant kickback into the net VINV as the switched end of the coupling capacitor CIN is either connected to the net VCOUPLE virtually equivalent to the quiet signal ground voltage VG, or to the noisy signal ground net VGN, meaning no significant voltage transition.

A bank 16 of latched comparators CMPP1, CMPP2, CMPN1, CMPN2 is used to compare the output voltage of the charge amplifier VCHARGE with a set of threshold voltages that may be centred around the analog signal ground voltage VG. The reference voltages used for comparison are VG+VTP1, VG+VTP2, VG-VTN1, VG-VTN2, respectively, wherein always VTP2>VTP1, VTN2>VTN2 and typically VTP1=VTN1, VTP2=VTN2. All comparators are clocked with the latch signal TRACK_N in such a way that the comparison decision is made on the rising edge of signal TRACK_N, simultaneous to the falling edge of signal TRACK_P.

That is, the comparison decisions are made at the end of the time window where the charge amplifier is in the track mode and the cascade of the inverting preamplifier, coupling network and charge amplifier copies or transfers the system input signal changes without inversion. The digital output signals of all comparators are updated when the comparison decisions are made at the time of a rising edge on signal TRACK_N and a falling edge on signal TRACK_P and remain constant until the next falling edge on signal TRACK_N. While not shown in Figure 2, additional digital latch circuits may be connected in cascade with the outputs of the latched comparators 16 to obtain digital output signals that remain constant for full one clock period, that is until the next rising edge on signal TRACK_N and the next falling edge on signal TRACK_P. Various configurations of the comparator bank can be implemented in general.

Here, the two configurations as described below might by of practical relevance.

According to a first example, and according to a so-called single configuration, the comparators CMPP2 and CMPN2 as illustrated in Fig. 2 are not implemented and/or outputs VPOS2 and VNEG2 are not used. Here, and with the implementation of the latched comparators CMPP1 and CMPN1 the following is valid: VTP1=VTN1=VT, that is, the comparison thresholds for comparators CMPP1 and CMPN1 are symmetrically centred around VG.

A pulse on signal VPOS1 indicates that VCHARGE>VG+VT and, as the charge amplifier is periodically initialized, this means that the system input voltage VRX has made a fast rising transition. For the purpose of subsequent calculation of the correlation factor, this corresponds to a signal value of +1.

Conversely, a pulse on signal VNEG1 indicates that VCHARGE<VG-VT and, as the charge amplifier is periodically initialized, this means that the system input voltage VRX has made a fast falling transition. For the purpose of subsequent calculation of the correlation factor, this corresponds to a signal value of -1.

According to a second example, and according to a so-called double configuration, the comparators CMPP2 and CMPN2 as illustrated in Fig. 2 are implemented and the outputs VPOS2 and VNEG2 are used in addition to the outputs VPOS1 and VNEG1.

All four comparators are implemented and all four outputs are used and the following is valid VTP1=VTN1=VT and VTP2=VTN2=2*VT.

A pulse on signals VPOS1 or VPOS2 indicates that VCHARGE>VG+VT, or VCHARGE>VG+2*VT, respectively. As the charge amplifier is periodically initialized, this means that the system input voltage VRX has made a rising transition, also indicating its magnitude. For the purpose of subsequent calculation of the correlation factor, this corresponds to signal values of +1 or +2, respectively.

Conversely, a pulse on signals VNEG1 or VNEG2 indicates that VCHARGE<VG-VT or VCHARGE<VG-2*VT, respectively. As the charge amplifier is periodically initialized, this means that the system input voltage VRX has made a falling transition, also indicating its magnitude. For the purpose of subsequent calculation of the correlation factor, this corresponds to signal values of -1 or -2, respectively.

In Fig. 5 an example operation of a single instance of the periodic charge discriminator with single configuration of the comparator array is illustrated. The traces are marked in accordance with the schematic in Figure 5. As can be seen, the system input voltage VRX includes the sharp edges corresponding to the useful signal as well as slow ramps corresponding to the low frequency interference. The preamplifier output voltage VINV is an inverted and optionally amplified copy of VRX. The charge amplifier output voltage VCHARGE follows the shape of VRX when the switch control clock VSW is high and is reset when VSW is low. Therefore, when a useful signal edge on VRX overlaps with a high level on VSW, a substantial peak on VCHARGE is generated. Conversely, when only a slow ramp on VRX is present, only a saw waveform of small amplitude is present on VCHARGE. Finally, a pulse on VPOS1 or VNEG1 is generated if VCHARGE crosses the VG+VT or VG-VT levels, respectively.

By way of example, the voltage change of the input signal VRX from t0 - t2 is comparatively low. At and after time t2, the input signal VRX is subject to rather strong rising transition. Accordingly, the inverted signal VINV falls proportionally. The amplified signal VCHARGE at the output node 33 of the periodically switchable charge amplifier circuit 12 shows a respective peak at t3, which is well above the first predefined threshold signal e.g. larger than VG+VT. Accordingly and at time t3 the first latched comparator CMPP1 generates a pulse on the respective digital signal VPOS1.

At times from t0 to t1 the output of the periodically switchable charge amplifier circuit 12 is below the predefined higher threshold signal VG+VT and above the predefined lower threshold signal VG-VT. Accordingly, and upon transferring the periodically switchable charge amplifier circuit 12 into the reset mode or clear mode the output signal VCHARGE is initialized. Hence, in the time interval from t0 to t1 and further in the time intervals from t1 to t2 there only evolves a comparatively small saw-tooth shaped amplitude or ripple that does not flip any comparator, bringing no activity at any digital output signal.

At a further time t4, the input signal VRX is subject to a falling transition. Accordingly, the inverted input signal VINV rises proportionally, which causes a characteristic dip in the output signal VCHARGE of the periodically switchable amplifier circuit 12, with signal value well below the second predefined threshold signal VG-VT. Accordingly, the second latched comparator CMPN1 flips and generates a pulse on the respective digital signal VNEG1.

While the architecture shown in Figure 2 is fully functional, the related waveforms shown in Figure 5 may indicate a potential risk of failed detection when the useful edge on the system input signal VRX does not occur within the time window of the charge discriminator 14, that is, the time slot where the switch control clock VSW is high and the charge amplifier is in the track mode. Such a risk might be significant because the system input signal is completely asynchronous to the receive clock but the clock frequencies on both the transmit side and the receive side are precisely matched during manufacture to comply with an underlying communication standard.

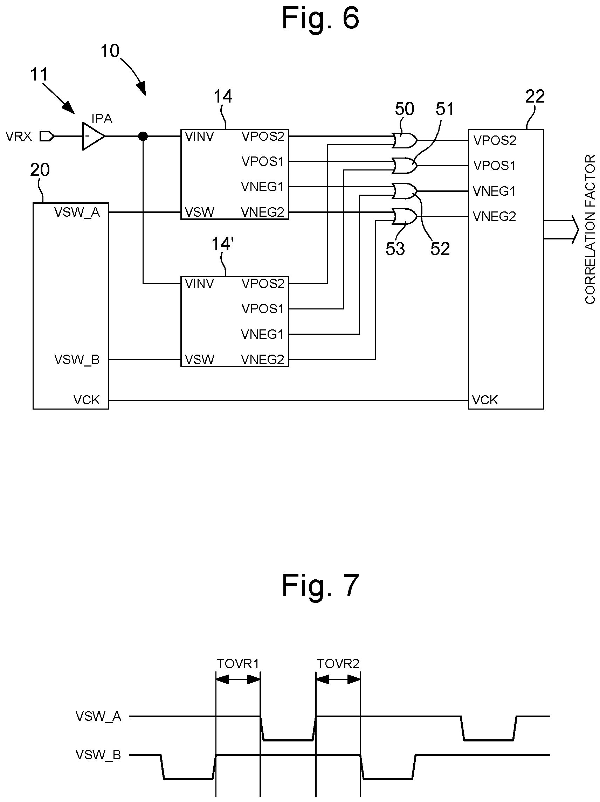

Here, the solution is to use a parallel combination of two periodic charge discriminators 14, 14' with a time window interleaving as depicted in Figures 6 - 9.

Fig. 6 shows the parallel combination, where two periodic charge discriminator units 14 and 14' share the same inverting preamplifier 11 IPA. This is possible because the coupling stage in the periodic charge discriminator 14, 14' presents negligible kickback into the preceding preamplifier stage, as described above.

The digital outputs of both periodic charge discriminators 14, 14' are then combined by logical OR gates 50, 51, 52, 53 forming the input signals VPOS1, VPOS2, VNEG1, VNEG2 of a digital implementation of a differential matched filter 22. As described above, the periodic charge discriminators can be implemented in either a single configuration, where only signals VPOS1, VNEG1 are used, or in a double configuration, where all four signals VPOS1, VNEG1, VPOS2, VNEG2 are used.

The receiver front end also includes a clock generator 20 that provides two switch control clock signals or master clock signals VSW_A, VSW_B and a clock signal VCK for the differential matched filter 22 to synchronously process the combined digital output signals VPOS1, VNEG1 and, if applicable, VPOS2, VNEG2.

In connection with Fig. 6, Fig. 7 shows the principle of time window interleaving. The two switch control clock signals VSW_A and VSW_B are shifted copies of the same pattern and are timed in such a way that the periods of high level, where the related periodic charge amplifiers are in track mode, overlap by time spaces TOVR1 and TOVR2. Therefore, at any given point of time, it is provided that at least one periodic charge amplifier is in the track mode and will stay in this mode for at least such amount of time that is the smaller of the two overlap times TOVR1, TOVR2.

Therefore, and when the arrival of the input signal is completely asynchronous with respect to the internal clock signals, the timing waveforms should be generated in such a way that the overlap times TOVR1, TOVR2 are identical.

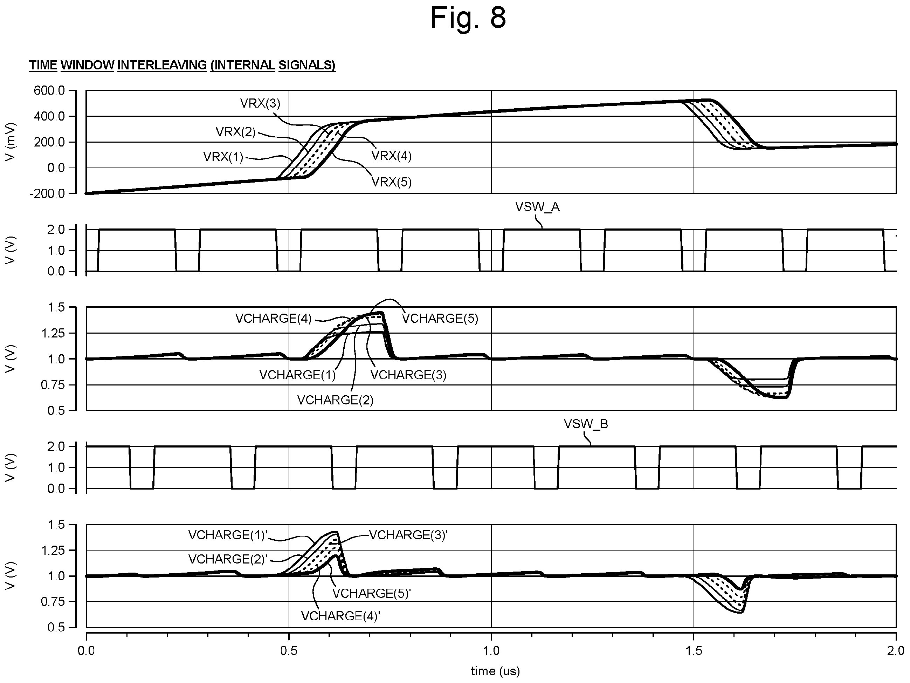

Fig. 8 illustrates the operation, showing the internal output signals of the two periodic charge amplifiers of the charge discriminators 14, 14' as the system input signal VRX is shifted in time as indicated by a series of signals VRX(1), VRX(2), VRX(3), VRX(4), VRX(5) with respect to the pair of clock signals VSW_A, VSW_B, focusing on the moments when the useful signal edges arrive. While the amount of charge changes in the discriminator 14 increases as illustrated with the signals VCHARGE(1), VCHARGE(2), VCHARGE(3), VCHARGE(5), VCHARGE(5), the amount of charge change in discriminator 14' decreases as indicated by the signals VCHARGE(1)', VCHARGE(2)', VCHARGE(3)', VCHARGE(5)', VCHARGE(5)', and for any time shift there is at least one discriminator block where the voltage VCHARGE indicating the charge change crosses the respective threshold in either direction and a successful detection takes place.

Finally, the resulting digital signal combination DSIG passed to the differential matched filter 22 is defined as a digital numeric value represented by the combined single bit signals VPOS1, NEG1 and, if applicable, VPOS2, VNEG2, at the inputs of the differential matched filter 22. A high level on signal VPOS1 or VNEG1 corresponds to a numeric value of +1 or -1, respectively. If implemented, a high level on signal VPOS2 or VNEG2 corresponds to a numeric value of +2 or -2, respectively. Furthermore, if implemented and high, VPOS2 takes precedence over VPOS1, that is, a high level on VPOS2 means the resulting numeric value is +2 regardless of VPOS1. Also, if implemented and high, VNEG2 takes precedence over VNEG1, that is, a high level on VNEG2 means the resulting numeric value is -2 regardless of VNEG1.

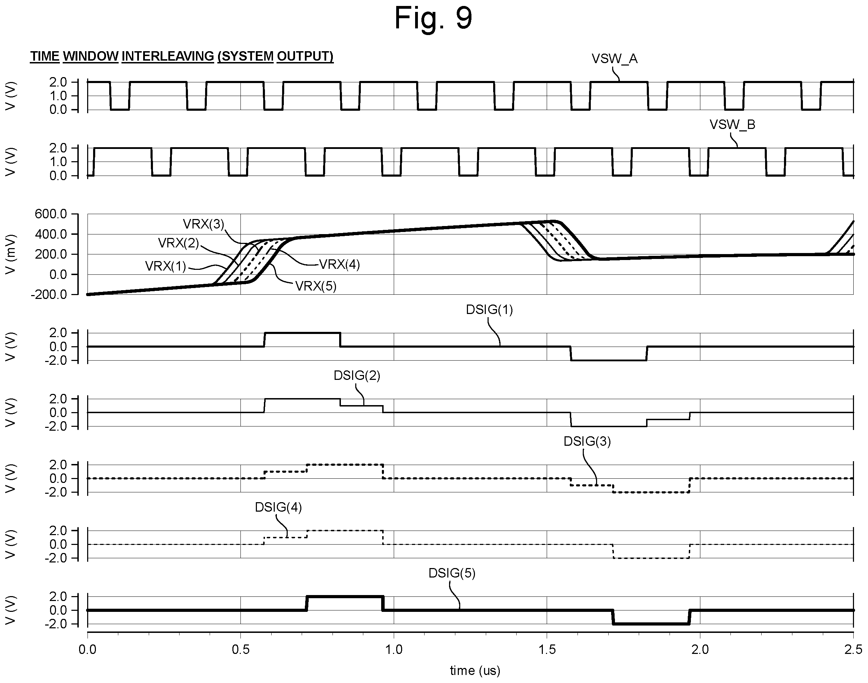

Fig. 9 presents the resulting numeric signals DSIG (1), DSIG (2), DSIG (3), DSIG (4) and DSIG (5) simulated for a receive chain of VRX signals VRX(1), VRX(2), VRX(3), VRX(4) and VRX(5), that have the same shape but arrive with gradually increasing delay and where the double configuration of comparators 14, 14' is used, that is, all four signals VPOS1, VPOS2, VNEG1, VNEG2 are implemented and used. Again, the system input signal is shifted in time with respect to the switch control clock signals VSW_A, VSW_B.

However, as can be seen, the resulting numeric signal DSIG (1), DSIG (2), DSIG (3), DSIG (4), and DSIG (5), always reach the peak values of +2 or -2 with a constant delay from the respective edge at the system input VRX.

While not shown in Figure 9, in the case of the single configuration of the comparators, wherein only signals VPOS1, VNEG1 are implemented and used, the resulting numeric signal reaches the peak values of +1 or -1 but the waveforms and their dependence on the time shift of the system input signal are fundamentally similar to those shown in Fig. 9.

In both cases, the numeric digital signal DSIG (1) - (5) is a suitable input to the differential matched filter 22, e.g. as described in US 5 663 983, in particular for the case where multiple samples are made within the duration of one bit or chip of the spreading code as presented in this publication, wherein the recommended sampling frequency or clock frequency to use at the input interface of the differential matched filter is an even multiple of the frequency used in the pair of clock signals VSW_A, VSW_B, that is, at least twice larger than said frequency.

### Nomenclature

- 1: spread spectrum modulation signal
- 10: receiver circuit
- 11: preamplifier
- 12: charge amplifier circuit
- 14: charge discriminator circuit
- 16: latched comparator bank
- 20: clock generator
- 22: differential matched filter
- 31: node
- 32: node
- 33: node
- 34: node
- 35: node
- 40: flip flop
- 41: NAND gate
- 42: NAND gate
- 43: inverter
- 44: inverter
- 45: inverter
- 46: delay element
- 47: delay element
- 50: OR gate
- 51: OR gate
- 52: OR gate
- 53: OR gate
- VRX: input signal
- VINV: inverted input signal
- VCOUPLE: input coupling net
- CST: status capacitor
- TRACK_P: track switch / track switch signal
- CLEAR_P: reset switch / reset switch signal
- TRACK_N: latch signal
- CIN: input capacitor
- OA: amplifier / operational amplifier
- VG: signal ground voltage
- VGN: noisy analog signal ground
- VGQ: quiet analog signal ground
- VPOS: output signal
- VNEG: output signal
- VCHARGE: output voltage
- VSW: master clock signal
- CMP: latched comparator
- TOVR: overlap time
- DSIG: digital signal combination

## Claims

1. A periodically switchable charge amplifier circuit (12) for amplifying an analog input signal (VRX), the switchable charge amplifier circuit (12) comprising:
- a status capacitor (CST),
- a track switch (TRACK_P) and at least a first reset switch (CLEAR_P) alternately switchable by a master clock signal (VSW), and
- an amplifier (OA) parallel to the status capacitor (CST),
- wherein the status capacitor (CST) is chargeable by closing the track switch (TRACK_P) and wherein the status capacitor (CST) is dischargeable by closing the at least first reset switch (CLEAR_P).

2. The charge amplifier circuit (12) according to claim 1, wherein the amplifier (OA) is connected to the status capacitor (CST) in a negative feedback configuration.

3. The charge amplifier circuit (12) according to any one of the preceding claims, wherein the at least first reset switch (CLEAR_P) is arranged parallel to the status capacitor (CST).

4. The charge amplifier circuit (12) according to any one of the preceding claims, further comprising an input node (31), which is selectively connectable to the arrangement of the status capacitor (CST), the amplifier (OA) and the at least first reset switch (CLEAR_P) via the track switch (TRACK_P).

5. The charge amplifier circuit (12) according to claim 4, wherein the input node (31) is capacitively coupled to the analog input signal (VRX) via an input capacitor (CIN).

6. The charge amplifier circuit (12) according to claim 4 or 5, wherein the input node (31) is connectable to a signal ground (VGN) via a second reset switch (CLEAR_P) concurrently switchable with the at least first reset switch (CLEAR_P).

7. A charge discriminator circuit (14) to generate digital output signals (VPOS1, VNEG1) on the basis of an analog input signal (VRX), the charge discriminator circuit (14) comprises:
- a charge amplifier circuit (12) according to any one of the preceding claims and
- at least a first latched comparator (CMPP1) and a second latched comparator (CMPN1) connected to an output node (33) of the charge amplifier circuit (12),
- wherein the first latched comparator (CMPP1) is configured to generate a first digital output signal (VPOS1) in response to detecting a signal at the output node (33) comprising a voltage value above a first predefined threshold signal (VG+VTP1) and
- wherein the second latched comparator (CMPN1) is configured to generate a second digital output signal (VNEG1) in response to detecting a signal at the output node (33) comprising a voltage value below a second predefined threshold signal (VG-VTN1).

8. The charge discriminator circuit (14) according to claim 7, further comprising a third latched comparator (CMPP2) and a fourth latched comparator (CMPN2) connected to the output node (33) of the charge amplifier circuit (12),
- wherein the third latched comparator (CMPP2) is configured to generate a third digital output signal (VPOS2) in response to detecting a signal at the output node (33) comprising a voltage value above a third predefined threshold signal (VG+VTP2) and
- wherein the fourth latched comparator (CMPN2) is configured to generate a fourth digital output signal (VNEG2) in response to detecting a signal at the output node (33) comprising a voltage value below a fourth predefined threshold signal (VG-VTN2).

9. A receiver circuit (10) comprising:
- at least one of a charge amplifier circuit (12) according to any one of the preceding claims 1-6 and a first charge discriminator circuit (14) according to claim 7 or 8, and
- a clock generator (20) coupled to at least one of the charge amplifier circuit (12) and at least one of the first and the second latched comparators (CMPP1, CMPN1) of the first charge discriminator circuit (14).

10. The receiver circuit (10) according to claim 9, wherein the clock generator (20) is configured to derive a track switch signal (TRACK_P) and a reset switch signal (CLEAR_P) on the basis of the master clock signal (VSW), wherein the track switch signal (TRACK_P) and the reset switch signal (CLEAR_P) are active in a complementary and non-overlapping way.

11. The receiver circuit (10) according to claim 9 or 10, wherein the clock generator (20) is coupled to the first and the second latched comparators (CMPP1, CMPN1) and is further configured to generate a latch signal (TRACK_N) on the basis of the master clock signal (VSW) to switch at least one of the first and the second latched comparators (CMPP1, CMPN1) into and out of a latched state.

12. The receiver circuit (10) according to any one of the preceding claims 9-11, further comprising a second charge discriminator circuit (14') according to any one of the preceding claims 7 or 8, wherein the first charge discriminator circuit (14) is coupled to a first clock signal output (VSW_A) of the clock generator (20) and wherein the second charge discriminator circuit (14') is coupled to a second clock signal output (VSW_B) of the clock generator (20), wherein the second clock signal output (VSW_B) is phase shifted to the first clock signal output (VSW_A).

13. The receiver circuit (10) according to claim 12, wherein the overlap times (TOVR1, TOVR2) during which the first and the second clock signal outputs (VSW_A, VSW_B) have the same signal level, are equal.

14. The receiver circuit (10) according to any one of the preceding claims 9-13, further comprising a differential matched filter (22) connected to an output of an OR gate (50, 51, 52, 53), which is connected to an output of the first charge discriminator circuit (14) and to an output of the second charge discriminator circuit (14').

15. The receiver circuit (10) according to any one of the preceding claims 9-14, further comprising an inverting preamplifier (IPA) to amplify and invert the analog input signal (VRX) and coupled to the at least one periodically switchable charge amplifier circuit (12).
